# EUROPEAN PATENT APPLICATION

(11) **EP 0 687 011 A1**
(43) Date of publication of application: **13.12.1995**
(21) Application number: 95108262.7
(22) Date of filing: 30.05.1995
(51) Int. Cl.: H01L 29/06

(54) **Planar semiconductor device with capacitively coupled field plates**

(30) Priority: 31.05.1994 JP 117297/94
(71) Applicant: FUJI ELECTRIC CO. LTD., Kawasaki 210 (JP)
(72) Inventor: Fujihira, Tatsuhiko, c/o Fuji Electric Co., Ltd., Kawasaki-shi, Kanagawa (JP)
(74) Representative: May, Hans Ulrich, Dr.

(57) **Abstract**

OBJECT
In series connected capacitors used for voltage division to flatten the distribution of an electric field strength due to a reverse voltage applied to a p-n junction are disposed without any increase in an area of a semiconductor substrate.

STRUCTURE
The series connected capacitors (C₁-C₅) are formed on an insulating film (4) which covers a surface of an end portion of the p-n junction (3). The capacitor used has a structure electric conductor/ dielectric/ electric conductor, a junction capacity of the p-n junction using a polycrystalline silicon, or a junction capacity of a Schottky junction. With this structure, the substrate area can be reduced in comparison with a structure using a capacity due to an in-substrate diffused layer.

## Description

### FIELD OF INDUSTRIAL APPLICATION

The present invention relates to a planar type semiconductor device having a structure for improving voltage sustaining capability (breakdown voltage) at an end portion of a p-n junction on a semiconductor substrate surface.

### PRIOR ART

In high voltage protection planar type semiconductor devices, namely various semiconductor devices such as diodes, bipolar transistors, power MOSFETs, insulated gate bipolar transistors (IGBT), thyristors or high voltage ICs, high breakdown voltage providing structures (high voltage withstanding structures) are provided at the end portions of p-n junctions on the surface of the semiconductor substrate. Such structures are designed to prevent reduction of the breakdown voltage which depends on the curvature of the p-n junction at the end portion thereof on the surface of the semiconductor substrate, see S.M. Sze and G. Gibbson: Solid-State Electronics, vol. 9, pp. 831 to 845 (1966). Various structures have been proposed as being exemplarily stated below.
(1) A structure with a guard ring or a field limiting ring (refer to K.-P Brieger et al.: Solid-State Electronics, vol. 26, pp. 739 to 745 (1983), US-A-4,412,242, and US-A-4,633,292).
(2) A structure with a field plate (refer to EP 0,937,115 and US-A-4,399,449).
(3) A structure with an adjusted (taylored) impurity concentration distribution (refer to US-A-4,344,080, Stengl and Goesele: Technical Digest of IEDM'85, pp.154 to 157 (1985), Boisson et al.: IEEE Transactions on Electron Devices, vol. ED-33, pp. 80 to 84 (1986)).
(4) A structure with a resistive film for providing a potential dividing effect (refer to US-A-4,270,137, Matsushita et al.: IEEE Transactions on Electron Devices, vol. ED-23, pp. 826 to 830 (1976).

### PROBLEMS TO BE SOLVED BY THE INVENTION

Among them, the structures with (1) the guard ring, (2) the field plate and (3) the impurity concentration distribution are liable to be affected by charges on the surface and also by wirings formed on those structures. The structure with the resistance film for the potential dividing effect, although it does not have the above shortcomings, has the drawback of requiring additional process steps for producing the resistance film with the result of increased cost and difficulty in adjusting the resistance value of the film.
In view of the above, the novel structure using the potential dividing effect due to series connected capacitances has been proposed. In this structure, impurity diffused layers in a semiconductor substrate have been constituted for a part of the structure of the series connected capacitors. A voltage divided by the series connected capacitors is applied between the diffused layers. In this structure, the breakdown voltage between adjacent diffused layers must be higher than the voltage applied between the diffused layers as a result of potential division. For satisfying this condition, the distance between the diffused layers in the semiconductor substrate cannot be reduced below a given value which depends on the impurity concentration of the semiconductor substrate. This has led to the problem that the reduction of the area is limited.
An object of the present invention is to provide a planar type semiconductor device which solves the foregoing problems and is capable of avoiding an increase of the area of a semiconductor substrate due to the improvement of the breakdown voltage using a potential dividing effect due to series connected capacitances.

### MEANS FOR SOLVING THE PROBLEMS

In order to solve the foregoing problems, according to the present invention, in a planar type semiconductor device where a semiconductor region of a second conductivity type is selectively formed on a surface layer of a semiconductor region of a first conductivity type in a semiconductor substrate, an exposed portion of a p-n junction between the semiconductor regions of the first and second conductivity types at the surface of the semiconductor substrate is covered with an insulating film, a plurality of capacitances are disposed on the insulating film so as to be connected in series, and either terminal of the series connected capacitances is connected to one of two electrodes at potentials equal to potentials capable of developing the reverse voltage, respectively. Preferably, said capacitances are disposed on the insulating film so as to be connected in series in a direction parallel with the surface of the semiconductor substrate. It is preferable that the capacitance is of a structure where a dielectric is interposed between electric conductors, is a junction capacitance of the p-n type junction or Schottky type junction, or is the combination of the two or more of the above structure or junction capacitances. In the structure where a dielectric is interposed between electric conductors, the dielectric is preferably embedded in each gap formed between a plurality of electric conductors on the insulating film. Alternatively, the electric conductors may be preferably comprised of a plurality of first electric conductors on the insulating film and a plurality of second electric conductors each being formed in the middle portion of the two adjacent first electric conductors so as to extend thereover in opposition thereto with the dielectric between the first and the second electric conductors. When the capacitance is a junction capacitance of a p-n junction, the p-n junctions may be preferably formed between p-type semiconductor regions and n-type semiconductor regions which are alternately adjacent to each other on the insulating film in a horizontal direction, or formed between a plurality of first conductive type semiconductor layers on the insulating film and a plurality of second conductive type semiconductor layers each being in contact with at least upper surfaces of the first conductive semiconductor type layers. When the capacitance is the junction capacitance of a Schottky junction, the Schottky junction may be preferably formed between adjacent semiconductor layers and Schottky electrodes which are alternately disposed on the insulating film in a horizontal direction. It is effective that the mentioned electric conductor or the first electric conductor is made of polycrystalline silicon, the second electric conductor is made of metal, the dielectric is made of CVD oxide, and the semiconductor region or the semiconductor layer is made of polycrystalline silicon. When the Schottky junctions are formed between a semiconductor layer made of polycrystalline silicon and a Schottky electrode, at least a portion of the Schottky electrode which is in contact with the semiconductor layer is made of a silicide.

### OPERATION

The capacitances, connected in series and arranged in a direction of an electric field developed by a reverse voltage to be applied to a p-n junction between a first conductivity type region in the planar type semiconductor device and a second conductivity type region formed on a surface layer thereof for dividing the reverse voltage, are disposed on the insulating film on the semiconductor substrate. This structure allows to reduce the area of the semiconductor substrate without any limitation. The series connected capacitances on the insulating film can be readily formed by a structure in which a dielectric is interposed between electric conductors, or by a junction capacitance of a p-n junction or a Schottky junction. In all cases, at least a part of the reverse voltage to be applied to the p-n junction within the semiconductor substrate is divided by the series connected capacitances, the resulting potential distribution affects the semiconductor substrate through the insulating film to flatten the electric field strength distribution in the vicinity of a surface of the semiconductor substrate, and thus the breakdown voltage of the p-n junction can be improved.

### EFFECT OF THE INVENTION

According to the present invention, series connected capacitors for improving voltage withstanding capability of a p-n junction are formed on the structure of an end portion of a p-n junction with an insulating film interposed therebetween, thereby enabling the improvement with a structural countermeasure in a narrower area. Also, the structure allows a wiring (lead wires) to be disposed on the series connected capacitors so that the voltage withstandingness of the p-n junction is not deteriorated by the provision of the wiring thereon. The wiring permits a control circuit section to be integrated into the same semiconductor substrate for enabling detection of an overvoltage applied to an output semiconductor device or abnormal conditions such as short-circuiting or disconnection in a load of the output semiconductor device. Further, the capacitors may be formed with p-n junctions, which are utilized as voltage regulating elements that has enabled an improvement in voltage withstanding capability against an overvoltage.

### EMBODIMENTS

Hereinafter, a description will be given of embodiments of the present invention with reference to the drawings where the same parts are designated by identical symbols.

Fig. 1 is a sectional view schematically showing a main part of a planar semiconductor device in accordance with an embodiment of the present invention.

Fig. 2 is a sectional view showing a main part of a planar semiconductor device in accordance with another embodiment of the present invention.

Fig. 3 is a sectional view showing a main part of a planar semiconductor device in accordance with still another embodiment of the present invention.

Fig. 4 is a sectional view showing a main part of a planar semiconductor device in accordance with still another embodiment of the present invention.

Fig. 5 is a sectional view showing a main part of a planar semiconductor device in accordance with still another embodiment of the present invention.

Fig. 6 is a plan view showing a semiconductor substrate of a planar semiconductor device in accordance with an embodiment of the present invention.

Fig. 7 is a sectional view showing a main part of a planar semiconductor device in accordance with yet still another embodiment of the present invention.

Fig. 8 is a sectional view showing a main part of a power horizontal MOSFET in accordance with an embodiment of the present invention.

Fig. 9 is a diagram showing an equivalent circuit of the power MOSFET of Fig. 8.

Fig. 10 is a plan view showing an IC substrate including the power MOSFET of Figs. 8 and 9.

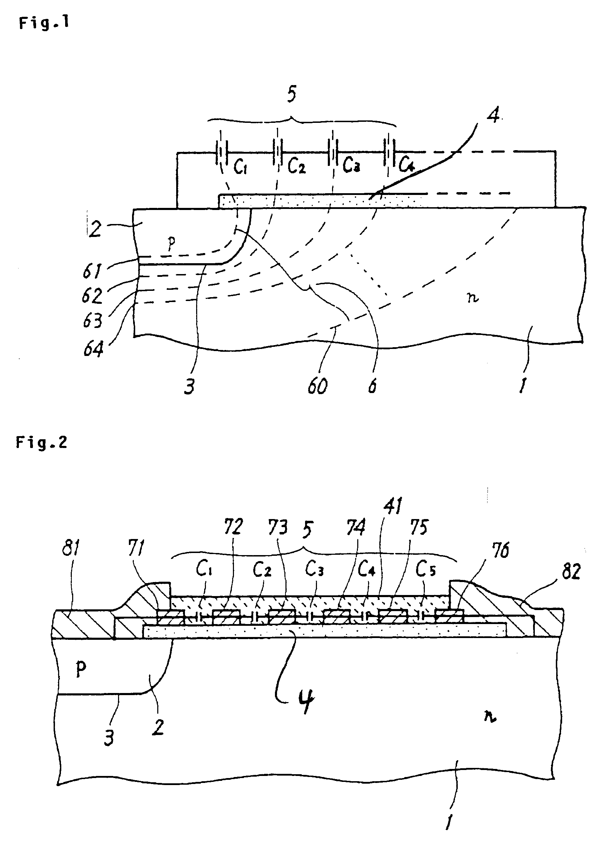

In a semiconductor device in accordance with an embodiment of the present invention schematically shown in Fig. 1, an exposed portion of a p-n junction 3 at a surface layer of an n-type silicon substrate 1, which junction is formed by selectively providing a p-type region 2 on the surface layer, is covered with a thermally oxidized film serving as an insulating film 4. The semiconductor device includes series connected capacitors 5 which consist of a plurality of capacitors C₁, C₂, C₃, C₄ ..... formed on the insulating film 4. The plurality of capacitors C₁, C₂, C₃ and C₄ ..... divide at least a part of a reverse voltage to be applied to the p-n junction 3. As a result, the distribution of the electric field strength of a depletion layer, which extends in the semiconductor substrate on both sides of the p-n junction 3 by the applied reverse voltage, is flattened in the vicinity of the substrate surface. As shown by equipotential lines 61, 62, 63, 64 ... 60 indicated by dotted lines in the figure, the intervals between the respective equipotential lines become widened on the surface portion of the n-type substrate 1 and the p-type region 2 which are directly below the insulating film 4. This shows that the distribution of the electric field strength is flattened on that portion.

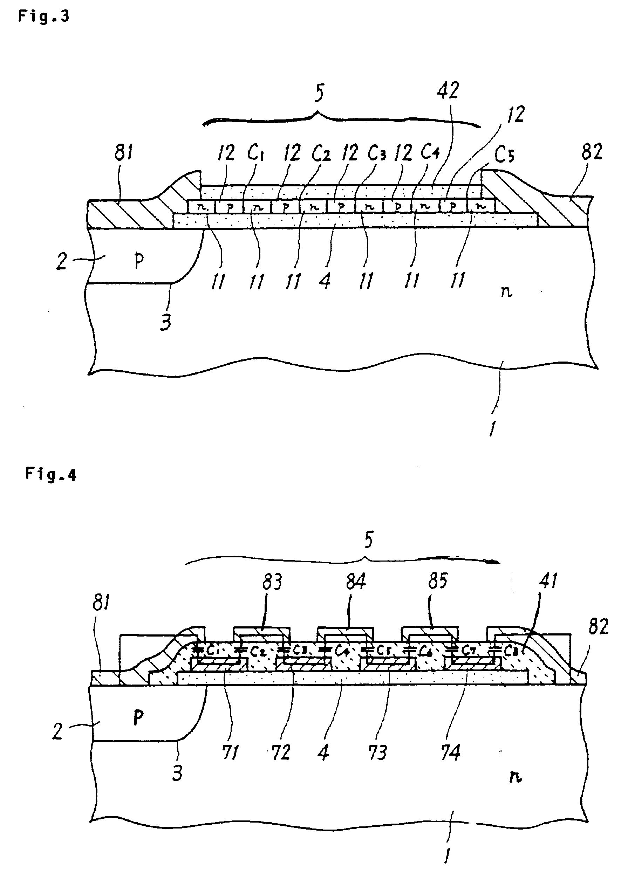

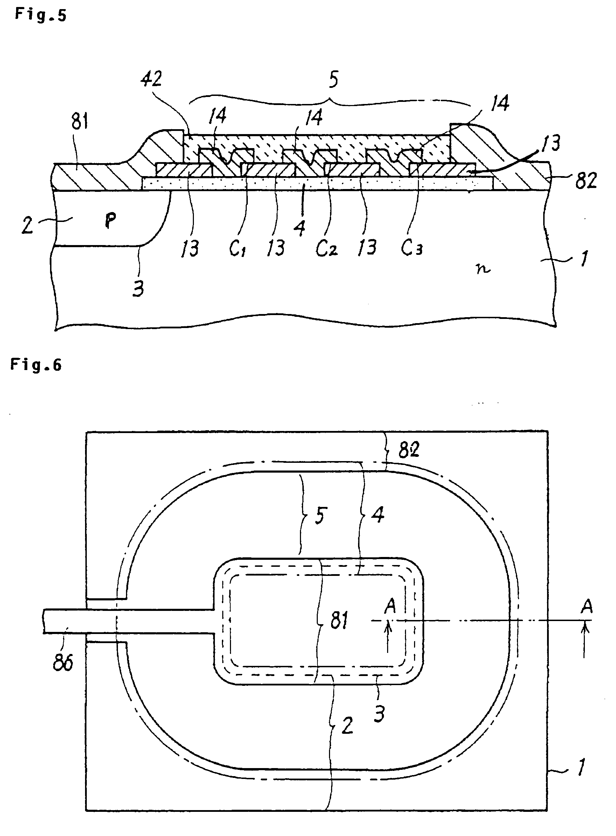

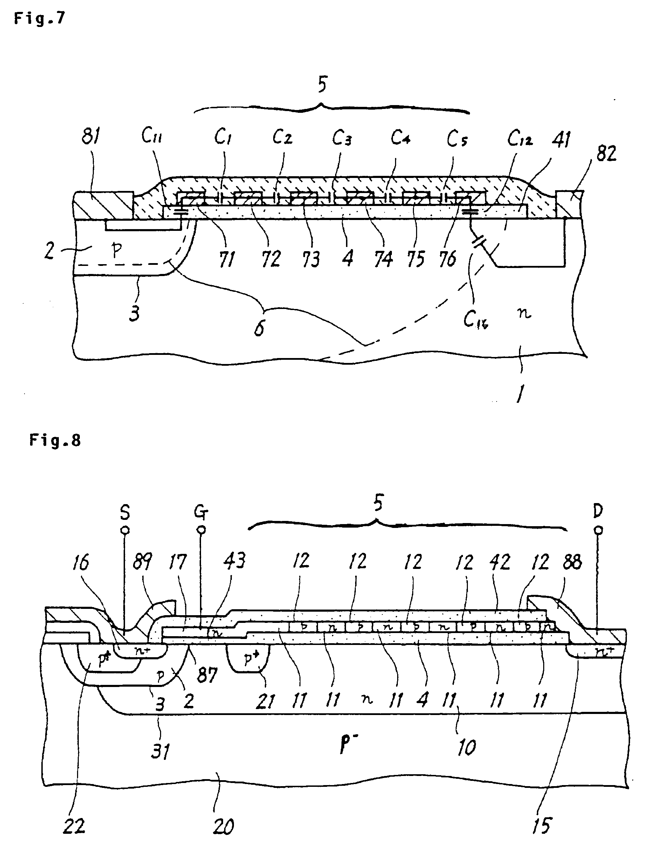

Figs. 2 to 5 show specific examples of the structures of the series connected capacitors of Fig. 1. In an embodiment of the present invention shown in Fig. 2, which corresponds to claims 3 and 7, an electrically conductive polycrystalline silicon layer has been deposited on an insulating layer 4 before being divided into electrically conductive layers 71, 72, 73, 74, 75 and 76 by providing grooves therebetween. A dielectric film 41 consisting of a CVD oxide film such as PSG + BPSG is formed so as to fill the grooves between the divided electrically conductive layers as well as cover the divided electrically conductive layers. This provides series connected capacitors 5 consisting of the electrically conductive layers 71 to 76 and the insulating film 41 filled into the spaces therebetween. Electrically conductive layers 71 and 76 formed on either terminal of the series capacity 5 are connected to a p-type region 2 and an n-type region 1 through electrodes 81 and 82 made of aluminum.
In another embodiment of the present invention shown in Fig. 3, which corresponds to claims 4 and 9, an electrically conductive polycrystalline silicon layer deposited on an insulating film 4 is doped by ion implantation so that it comprises alternately n-type semiconductor regions 11 having an impurity concentration about 10²⁰ cm⁻³ and p-type semiconductor regions 12 having an impurity concentration about 10¹⁹ cm⁻³, and electrodes 81 and 82 are brought to be in contact with the n-type semiconductor regions 11 at either end of the silicon layer. As a result, among p-n junctions formed by the p-type regions 12 and the n-type regions 11 with a withstand voltage of about 10 V, the reverse-biased p- n junctions disposed at every two ones function as C₁, C₂, ... C₅ of the series connected capacitors 5. In this case, an insulating film 42 consisting of PSG + BPSG, which covers the series capacitors 5, serves as a protective film for the p-n junctions as well as an interlayer insulating film for wirings when it is disposed on the series capacitors 5.
In another embodiment of the present invention shown in Fig. 4, which corresponds to claims 3 and 8, a polycrystal silicon film deposited on an insulating film 4 is split into first electrically conductive layers 71, 72, 73 and 74, on which is coated a dielectric film 41 consisting of a CVD oxide film. On the dielectric film 41 second electrically conductive layers 83, 84 and 85 consisting of aluminum are disposed right above the middle position between a pair of adjacent first electrically conductive layers. Above the electrically conductive layers 71 and 74 at either end of the first electrically conductive layers 71 to 74 electrodes 81 and 82 are provided with their end portions respectively opposing the layers 71 and 74. This provides capacitors C₁ to C₈ each having the structure electric conductor/dielectric/electric conductor as shown in the figure, thereby forming series connected capacitors. Like the previous case, with an additional insulating film being formed on the dielectric film, wirings may be disposed on the insulating film. The polycrystal silicon film used for the electrically conductive layers 71, 72, 73, ..... in accordance with the embodiments shown in Figs. 2 and 4 may be p-type or n-type.
In still another embodiment of the present invention shown in Fig. 5, which corresponds to claims 5 and 11, an n-type polycrystalline silicon layer on an insulating film 4 is divided into n-type semiconductor layers 13. Schottky electrodes 14 made of metal with high barrier height for n-type semiconductors each formed by dividing a platinum layer or the like are provided so as to bridge each gap between the n-type semiconductor layers 13. Of the Schottky junctions formed at the interfaces between the Schottky electrodes 14 and the n-type semiconductor layers 13, reverse-biased junctions constituting junction capacities C₁, C₂ and C₃ form series connected capacitors 5. In this case, the Schottky junction is not necessarily a metal/semiconductor junction, but may be also a metal silicide/semiconductor junction for which a portion of a metal layer in contact with a silicon semiconductor layer is heat-treated to be silicified after brought into contact with an upper surface of the silicon layer. An unsilicified portion of the metal layer functions as a connecting electrode. In this embodiment, like that in Fig. 3, a coating insulating film 42 serves as a protective film for the Schottky junction as well as an interlayer insulating film for disposing wirings thereon. The series connected capacitors 5 consisting of C₁, C₂ and C₃ in the structure of Fig. 5 may be obtained also by providing a p-n junction instead of a Schottky junction by substituting a p-type polycrystalline silicon layer for the Schottky electrode 14. This structure corresponds to claim 9. In the structure of Fig. 5, it is apparent that the series capacity 5 can also be obtained by exchanging the semiconductor layer 13 and the Schottky electrode 14, or the n-type semiconductor layer and the p-type semiconductor layer.
Fig. 6 is a plan view showing a semiconductor device chip in accordance with the foregoing embodiments of the present invention. In the figure, an edge portion of the p-type region 2 shown by a dotted line represents an exposed portion of the p-n junction 3 at the surface. Inner and outer edges of the series connected capacitors 5 formed in an annular shape on the insulating film 4, the contours of which are illustrated by chain lines, are connected to an electrode 81 in contact with the p-type region 2 and an electrode 82 in contact with the n-type substrate 1, respectively. A lead wire 86 connected to the electrode 81 is led to the exterior over the insulating film 4. Illustrations in Figs 1 to 5 become more understandable by regarding them as sectional views taken along a line A-A of Fig. 6.
In the embodiments of the present invention shown in Figs. 1 to 5, either terminals of the series connected capacitors are connected to the p-type region 2 through the electrode 81 and to the n-type substrate 1 through the electrode 82. However, the structure of the present invention is not limited to such a connection. For example, in still another embodiment shown in Fig. 7, the first electrically conductive layers 71 and 76, which are connected to the electrodes 81 and 82 in the embodiment shown in Fig. 2, are modified so as to be disconnected from those electrodes. Even by this structure, a similar effect of the invention can be obtained. Namely, as schematically shown in the figure, an insulating film 4 provides an insulating film capacitance C₁₁ as being interposed between the electrically conductive layer 71 and the electrode 81, and the insulating film 4 and a depletion layer 6 extending from the p-n junction 3 formed between the n-type substrate 1 and the p-type region 2 provide an insulating film capacitance C₁₂ and a depletion layer capacitance C₁₆ as being interposed between the electrically conductive layer 76 and the electrode 82. However, for a satisfying result, this structure should be designed so that the insulating film capacitance C₁₁, C₁₂ and the depletion layer capacitance C₁₆ are not smaller than the capacitances C₁ to C₅. It is apparent that a similar modification is also applicable to the embodiments shown in Figs. 3 to 5.

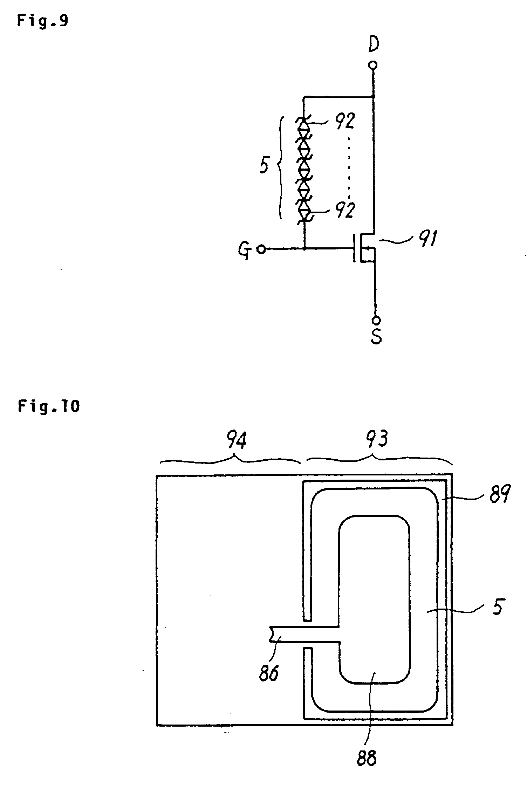

Fig. 8 shows a horizontal n-channel high voltage protection power MOSFET in accordance with still another embodiment of the present invention. The MOSFET has n-type region 10 on a surface layer of a p-type silicon substrate 20. On a surface layer of the n-type region 10 a n⁺-type drain contact region 15 and a p-type region 2 as a base region are formed separately from each other. A p⁺-type region 21 as an electric field relaxation region is formed at a position in proximity to the base region 2 between the n⁺-type drain contact region 15 and the base region 2. A p⁺-type base contact region 22 and an n⁺-type source region 16 are formed in the base region 2. Like the structure of Fig.3, series connected capacitors 5 utilizing p-n junction capacitances consisting of n-type regions 11 of polycrystalline silicon and p-type regions 12 are disposed on an insulating film 4 which covers a closed curve 87 being an exposed portion of a p-n junction 3 at the surface. The p-n junction 3 is formed on an interface between the p-type base region 2 and the n-type region 10 or the substrate 20. The series connected capacitors are covered with an insulating film 42. The MOSFET also includes a drain electrode 88 and a source electrode 89. The drain electrode 88 is in contact with the drain contact region 15 and connected to a terminal D. The source electrode 89 is connected to a terminal S and the base contact region 22 commonly in contact with the source region 16 through which it is connected to the base region 2 and the substrate 20. The n-type region 11 disposed at one end of the series connected capacitors 5 is connected to the drain electrode 88 whereas the n-type region at the other end, which is adjacent to the p-type region 12, is extended over a thin gate insulating film 43 connected to the insulating film 4 and is formed into a gate electrode 17 with a terminal G connected thereto. This embodiment is characterized in that the series connected capacitors 5 consisting of the p-n junction capacities are connected between the gate terminal G of the MOSFET and the drain terminal D of the MOSFET. The potential of the source terminal S is nearly equal to the potential of the gate terminal G, whereby this structure simultaneously improves the breakdown voltage between the drain and the source. The series connected capacitors 5 thus constituted serves not only as means for flattening the electric field strength but also as a voltage regulating or control element for absorbing an overvoltage. In other words, as shown in an equivalent circuit of Fig. 9, the structure formes a circuit in which voltage regulating elements 92 are disposed between the drain and gate of the MOSFET 91 in series connection with their directions alternately reversed. An overvoltage applied between the drain terminal D (electrode 87) and the gate terminal G (electrode 17) of the MOSFET 91 causes the constant-voltage elements 92 alternately to break down, and the resulting break-down current allows the gate electrode of the MOSFET 91 to be biased for turning on. The resulting forward current of the MOSFET 91 serves to restrict an excessive voltage applied, thereby enhancing the capability to withstand the excessive voltage.

Fig. 10 illustrate a plan view of an IC chip which integrates an output semiconductor device 93, a MOSFET embodied in Fig. 8 or 9, with a control circuit section 94. A lead 86 is led out from a drain electrode 88 to the control circuit section 94 over series capacitors 5 with an interlayer insulating film provided therebetween. The lead 86 allows the potential of the drain electrode 88 to be detected in the control circuit section 94, thereby being capable of sensing abnormal conditions such as an overvoltage applied to the output semiconductor device 93, a short-circuiting or disconnection in a load of the output semiconductor device 93.
The improvement of the capability to withstand higher voltages by the structure of the series connected capacitors as shown in Fig.8 is not limited to be applied to the horizontal n-channel high voltage protection power MOSFET, but can be applied to any type of high voltage protection (rating) power MOSFET such as vertical type or p-channel type, or to any other power devices such as an IGBT, a bipolar transistor, a thyristor including a GTO, or an SIT. The IC into which an output semiconductor device using those types of power device is integrated with a control circuit section as shown in Fig. 9 is called a power IC, an intelligent power IC, an intelligent power device or a smart power device, examples of which have been disclosed e.g. in US-A-5,053,838 or the like.
In the foregoing embodiments, silicon was used as semiconductor substrate material and a silicon oxide film was used as an insulating film However, the materials for the present invention are not limited to those materials. Also, p-type and n-type may be exchanged. Moreover, for the improvement of voltage withstanding capability, the means according to the present invention is not necessarily carried out independently, but may be effectively combined with one or more conventional techniques for improving voltage withstanding capability in which a guard ring or a field plate is used, an impurity concentration is controlled, a resistance film is used.

### DESCRIPTION OF LEGENDS

Reference numeral
- 1: denotes an n-type Si substrate;
- 2,: a p-type region;
- 3,: a p-n junction;
- 4,: an insulating film;
- 41,: a dielectric film;
- 5,: a series connected capacitors;
- 6,: a depletion layer;
- 71 to 76 and 83 to 85,: electrically conductive layers;
- 81 and 82,: electrodes;
- 11,: an n-type region;
- 12,: a p-type region;
- 13,: an n-type region; and
- 14,: a Schottky electrode.

## Claims

1. A planar type semiconductor device in which a semiconductor region (2) of a second conductivity type is selectively formed on a surface layer of a semiconductor region (1) of a first conductivity type in a semiconductor substrate (1), **characterized in that** an exposed portion of a p-n junction (3) between the semiconductor regions of the first and second conductivity types at the surface of the semiconductor substrate is covered with an insulating film (4); that a plurality of capacitances (5) are disposed on the insulating film (4) so as to be connected in series, and that either terminal of the series connected capacitances (5) is connected to one of two electrodes at potentials equal to potentials capable of developing the reverse voltage.

2. A planar type semiconductor device as claimed in claim 1, **characterized in that** said capacitances (5) are disposed on the insulating film (4) so as to be connected in series in a direction parallel with the surface of the semiconductor substrate.

3. A planar semiconductor device as claimed in claim 1, wherein the capacitance is formed by a structure in which a dielectric (41) is interposed between electric conductors (71 to 76).

4. A planar semiconductor device as claimed in claim 1, wherein the capacitance is the junction capacitance of a p-n junction (11 -12 in Fig. 3).

5. A planar semiconductor device as claimed in claim 1, wherein the capacitance is the junction capacitance of a Schottky junction (13-14 in Fig.5).

6. A planar semiconductor device as claimed in claim 1, wherein said plurality of capacitances comprise at least two types of the following types of capacitances: a capacitance due to a structure in which a dielectric (41) is interposed between electric conductors (71-76), a junction capacitance of a p-n junction (11-12), and a junction capacitance of a Schottky junction (13-14).

7. A planar semiconductor device as claimed in claim 3 or 6, wherein the dielectric (41) is embedded in each gap between a plurality of electric conductors (71-76) on the insulating film (4).

8. A planar semiconductor device as claimed in claim 3 or 6, wherein the electric conductors comprise a plurality of first electric conductors on the insulating film and a plurality of second electric conductors each being formed in the middle portion of the two adjacent first electric conductors so as to be extended thereover in opposition thereto with the dielectric between the first and the second electric conductors.

9. A planar semiconductor device as claimed in claim 4 or 6, wherein the p-n junctions are formed between p-type semiconductor regions (12) and n-type semiconductor regions (11) which are alternately adjacent to each other on the insulating film (4) in a horizontal direction.

10. A planar semiconductor device as claimed in claim 4 or 6, wherein the p-n junctions are formed between a plurality of first conductivity type semiconductor layers on the insulating film and a plurality of second conductivity type semiconductor layers each being in contact with at least upper surfaces of the two first conductivity type semiconductor layers.

11. A planar semiconductor device as claimed in claim 5 or 6, wherein the Schottky junction is formed between adjacent semiconductor layers (13) and Schottky electrodes (14) which are alternately disposed on the insulating film (4) in a horizontal direction.

12. A planar semiconductor device as claimed in claim 7 or 8, wherein the electric conductor or the first electric conductor is made of polycrystalline silicon.

13. A planar semiconductor device as claimed in claim 8, wherein the second electric conductor is made of metal.

14. A planar semiconductor device as claimed in claim 3, 6, 7, 8, 12 or 13, wherein the dielectric is made of CVD oxide.

15. A planar semiconductor device as claimed in claim 9, 10 or 11, wherein the semiconductor region or the semiconductor layer is made of polycrystalline silicon.

16. A planar semiconductor device as claimed in claim 11 or 14, wherein at least a portion of the Schottky electrode which is in contact with the semiconductor layer is made of silicide.
